# EUROPEAN PATENT APPLICATION

(11) **EP 4 635 790 A1**
(43) Date of publication of application: **22.10.2025**
(21) Application number: 23907510.4
(22) Date of filing: 05.12.2023
(51) Int. Cl.: B60L 58/16, B60L 53/80, B60L 3/00, G01R 31/392, G01R 31/396, G01R 31/367, G01R 31/3842, G07C 5/02

(54) **APPARATUS FOR PROVIDING BATTERY LIFE INFORMATION AND OPERATING METHOD THEREOF**

(30) Priority: 21.12.2022 KR 20220181137
(71) Applicant: LG Energy Solution, Ltd., Seoul 07335 (KR)
(72) Inventor: RO, Chang Suk, Daejeon 34122 (KR)
(74) Representative: Plasseraud IP
(86) International application number: PCT/KR2023/019905
(87) International publication number: WO 2024/136224

(57) **Abstract**

A battery life information providing apparatus according to an embodiment disclosed herein includes a determining unit configured to determine whether a first battery pack included in a first vehicle is replaced, based on a reference electric expense and first data regarding the first vehicle, a calculating unit configured to calculate a first replacement driving distance of the first vehicle, based on the first data, and a diagnosing unit configured to calculate life information regarding the first battery pack based on the first replacement driving distance and the first data.

## Description

### [TECHNICAL FIELD]

### CROSS-REFERENCE TO RELATED APPLICATION

This application claims priority to and the benefit of Korean Patent Application No. 10-2022-0181137 filed in the Korean Intellectual Property Office on December 21, 2022, the entire content of which is incorporated herein by reference.

### TECHNICAL FIELD

Embodiments disclosed herein relate to a battery life information providing apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Batteries mounted on electric vehicles tend to deteriorate as they are repeatedly charged and discharged. For example, as batteries mounted on electric vehicles are repeatedly charged and discharged for driving thereof, their capacity and resistance may deteriorate and their remaining life may decrease. In addition, the degree of deterioration and remaining life of the battery may change depending on use conditions of the electric vehicles.

When the remaining life of the battery rapidly decreases, safety issues may occur in the use of the electric vehicles. Accordingly, a method for diagnosing a state of a battery mounted on an electric vehicle in advance and preventing a risk due to a sharp decline in battery performance and a method for providing battery life information to a user.

In particular, when there is a history of battery replacement, user convenience may be improved by providing life information reflecting a replacement history.

### [DISCLOSURE]

### [TECHNICAL PROBLEM]

Embodiments disclosed herein aim to determine a reference electric expense based on driving data and determine whether a battery pack is replaced, based on the reference electric expense and state data of a battery pack.

Embodiments disclosed herein aim to provide an apparatus for providing life information of a battery pack by reflecting whether the battery pack is replaced and an operating method of the apparatus.

Technical problems of the embodiments disclosed herein are not limited to the above-described technical problems, and other unmentioned technical problems would be clearly understood by one of ordinary skill in the art from the following description.

### [TECHNICAL SOLUTION]

A battery life information providing apparatus according to an embodiment of the present disclosure includes a determining unit configured to determine whether a first battery pack included in a first vehicle is replaced, based on a reference electric expense and first data regarding the first vehicle, a calculating unit configured to calculate a first replacement driving distance of the first vehicle, based on the first data, and a diagnosing unit configured to calculate life information regarding the first battery pack based on the first replacement driving distance and the first data.

According to an embodiment, the battery life information providing apparatus may further include an electric expense determining unit configured to receive a plurality of pieces of second data for second vehicles of the same type as a first vehicle and calculate the reference electric expense based on the plurality of pieces of second data.

According to an embodiment, the plurality of pieces of second data may include a plurality of second accumulative discharging currents for second battery packs respectively included in the second vehicles and a plurality of second accumulative driving distance for the second vehicle.

According to an embodiment, the electric expense determining unit may be further configured to determine whether a second battery pack is replaced, and calculate the reference electric expense based on the plurality of pieces of second data for the second vehicles including second battery packs not replaced.

According to an embodiment, the electric expense determining unit may be further configured to calculate second electric expenses based on the plurality of second accumulative driving distances with respect to the plurality of second accumulative discharging currents and determine a third quartile electric expense of the second electric expenses as the reference electric expense.

According to an embodiment, the electric expense determining unit may be further configured to calculate an average electric expense of the second electric expenses, the first data may include a first accumulative discharging current for the first battery pack and a first accumulative driving distance for the first vehicle, the calculating unit may be further configured to calculate, as a driving distance before replacement, an accumulative driving distance when an accumulative discharging current is 0 in a straight line having an average electric expense as a gradient of the first accumulative driving distance with respect to the first accumulative discharging current, and calculate, as the first replacement driving distance, a result of subtracting the driving distance before replacement from the first accumulative driving distance.

According to an embodiment, the first data may further include a first accumulative discharging voltage for the first battery pack, and the diagnosing unit may be further configured to calculate the life information based on the first accumulative discharging current and the first accumulative discharging voltage with respect to the first replacement driving distance.

According to an embodiment, the first data may include a first accumulative discharging current for the first battery pack and a first accumulative driving distance for the first vehicle, and the determining unit may be further configured to determine that the first battery pack is replaced, when the first accumulative driving distance with respect to the first accumulative discharging current exceeds the reference electric expense.

An operating method of a battery life information providing apparatus according to another embodiment of the present disclosure includes determining whether a first battery pack included in a first vehicle is replaced, based on a reference electric expense and first data regarding the first vehicle, calculating a first replacement driving distance of the first vehicle, based on the first data, and calculating life information regarding the first battery pack based on the first replacement driving distance and the first data.

According to an embodiment, the operating method may further include receiving a plurality of pieces of second data for second vehicles of the same type as a first vehicle and calculating the reference electric expense based on the plurality of pieces of second data.

According to an embodiment, the plurality of pieces of second data may include a plurality of second accumulative discharging currents for second battery packs respectively included in the second vehicles and a plurality of second accumulative driving distances for the second vehicles.

According to an embodiment, the calculating of the reference electric expense may include determining whether a second battery pack is replaced and calculating the reference electric expense based on the plurality of pieces of second data for the second vehicles including second battery packs not replaced.

According to an embodiment, the calculating of the reference electric expense may include calculating second electric expenses based on the plurality of second accumulative driving distances with respect to the plurality of second accumulative discharging currents and determining a third quartile electric expense of the second electric expenses as the reference electric expense.

According to an embodiment, the first data may include a first accumulative discharging current for the first battery pack and a first accumulative driving distance for the first vehicle, and the calculating of the first replacement driving distance may include calculating an average electric expense of the second electric expenses, calculating, as a driving distance before replacement, an accumulative driving distance when an accumulative discharging current is 0 in a straight line having an average electric expense as a gradient of the first accumulative driving distance with respect to the first accumulative discharging current, and calculating, as the first replacement driving distance, a result of subtracting the driving distance before replacement from the first accumulative driving distance.

According to an embodiment, the first data may further include a first accumulative discharging voltage for the first battery pack, and the calculating of the life information regarding the first battery pack may further include calculating the life information based on the first accumulative discharging current and the first accumulative discharging voltage with respect to the first replacement driving distance.

According to an embodiment, the first data may include a first accumulative discharging current for the first battery pack and a first accumulative driving distance for first vehicle, and the determining of whether the first battery pack is replaced may include determining that the first battery pack is replaced, when the first accumulative driving distance with respect to the first accumulative discharging current exceeds the reference electric expense.

### [ADVANTAGEOUS EFFECTS]

A battery life providing apparatus and an operating method thereof according to an embodiment disclosed herein may determine whether a battery pack is replaced.

The battery life providing apparatus and the operating method thereof according to an embodiment disclosed herein may calculate a driving distance of a vehicle after replacement of a battery pack and calculate life information of the battery pack based on the driving distance of the vehicle.

Moreover, various effects recognized directly or indirectly from the disclosure may be provided.

### [DESCRIPTION OF DRAWINGS]

FIG. 1 is a block diagram showing a configuration of a vehicle including a battery pack.
FIG. 2 is a block diagram showing a battery life information providing apparatus according to an embodiment disclosed herein.
FIG. 3 is a view for describing an operating method of an electric expense determining unit, according to an embodiment disclosed herein.
FIG. 4 is a view for describing a method for determining whether a battery pack is replaced and a method for calculating a replacement driving distance.
FIG. 5 is a view for describing life information calculated by a diagnosing unit according to an embodiment disclosed herein.
FIG. 6 is a view for describing an operating method of a battery life information providing apparatus, according to an embodiment disclosed herein.
FIG. 7 is a view for describing an operating method of a battery life information providing apparatus, according to another embodiment disclosed herein.
FIG. 8 is a view for describing an operating method of a battery life information providing apparatus, according to another embodiment disclosed herein.
FIG. 9 is a block diagram showing a hardware configuration of a computing system for performing an operating method of a battery life information providing apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

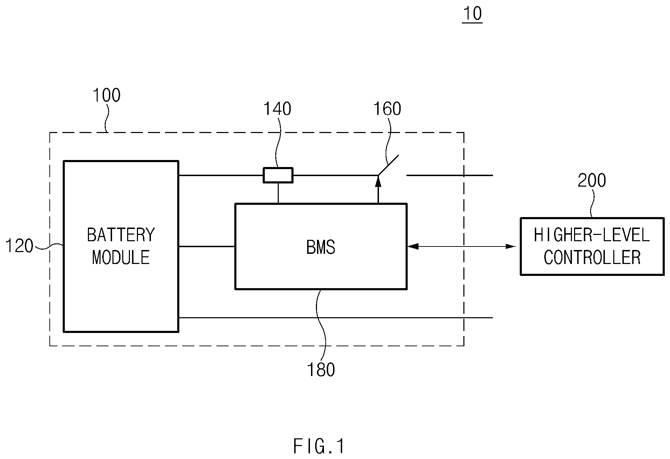

FIG. 1 is a block diagram showing a configuration of a vehicle including a battery pack.

Referring to FIG. 1, a vehicle 10 according to an embodiment of the present disclosure may include a battery pack 100 and a higher-level controller 200.

As shown in FIG. 1, the battery pack 100 may include a battery module 120 that includes one or more battery cells and is chargeable/dischargeable, a switching unit 160 serially connected to a positive (+) terminal side or a negative (-) terminal side of the battery module 120 to control a charging/discharging current flow of the battery module 120, and a battery management system (e.g., RBMS) 180 for control and management to prevent over-charge, over-discharge, etc., of the battery pack 100 and for monitoring data regarding the battery module 120. The battery pack 100 may include the battery module 120, the sensor 140, the switching unit 160, and the battery management system (BMS) 180 provided in plural.

The sensor 140 may be connected between the battery module 120 and the battery management system 180 to sense a voltage, a current, a temperature, an internal resistance, an impedance, etc., of the battery module 120 and transmit the same to the battery management system 180.

As the switching unit 160 which is an element for controlling a current flow for charging or discharging of the battery module 120, for example, at least one relay, magnetic contactor, etc., may be used according to specifications of the battery pack 100.

The battery management system 180, which is an interface for receiving measurement values of the above-described various parameters, may include a plurality of terminals and a circuit, etc., connected thereto to process input values. The battery management system 180 may control on/off of the switching unit 160, e.g., a relay, a contactor, etc., and may be connected to the battery module 120 to monitor the state of each battery module 120.

The higher-level controller 200 may transmit a control signal regarding the battery module 100 through the battery management system 180. The battery management system 180 may be controlled in terms of an operation thereof based on a signal applied from the higher-level controller 200.

According to an embodiment, the battery management system 180 may receive data such as a voltage, a current, a temperature, an internal resistance, an impedance, the number of times of charge and discharge, charging/discharging current, a charging/discharging voltage, etc., of the battery modules 120 from the sensor 140.

The data such as the voltage, current, temperature, internal resistance, impedance, the number of times of charge and discharge, charging/discharging current, charging/discharging voltage, etc., of the battery module 120 may be data that is a basis for determining life information of the battery pack 100 included in the vehicle.

The battery management system 180 may transmit the data to an external device (e.g., the battery life information providing apparatus, etc.).

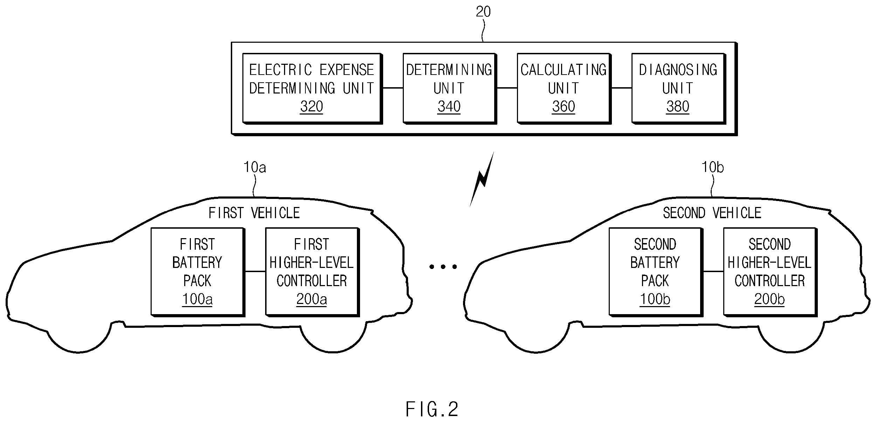

The higher-level controller 200 may receive data regarding driving of the vehicle 10 from another controller (e.g., a vehicle control unit (VCU)) included in the vehicle 10. For example, data regarding driving of the vehicle 10 may include information about an accumulative driving distance of the vehicle. The accumulative driving distance may be a total distance the vehicle 10 travels since release of the vehicle 10. The higher-level controller 200 may provide the data received from the other controller included in the vehicle 10 to the battery life information providing apparatus (20 of FIG. 2).

The battery life information providing apparatus may receive the data from the battery management system 180 and the higher-level controller 200. That is, the battery life information providing apparatus may receive the data regarding the vehicle 10.

The battery life information providing apparatus may calculate life information regarding the battery pack 100 based on the received data.

The life information regarding the battery pack 100 may include, for example, a state of health (SOH) that is a performance index indicated by comparing an ideal state of the battery pack 100 with the current state of the battery pack 100.

According to an embodiment, the battery life information providing apparatus may calculate the SOH based on the driving distance of the vehicle 10 including the battery pack 100, and the accumulative discharging current and accumulative discharging voltage of the battery pack 100.

Data collected by the battery pack 100 and the higher-level controller 200 may respectively correspond to a plurality of vehicles. The data may be affected by a driving habit of a driver, an environment where the vehicle is driven.

The battery life information providing apparatus may be connected to the plurality of vehicles through a network to receive data collected for each vehicle.

FIG. 2 is a block diagram showing a battery life information providing apparatus according to an embodiment disclosed herein.

In FIG. 2, vehicles 10a and 10b connected to the battery life information providing apparatus 20 through the network are shown.

The vehicles may be respectively referred to as a first vehicle 10a and a second vehicle 10b, in which the first vehicle 10a may include a first battery pack 100a and a first higher-level controller 200a and the second vehicle 10b may include a second battery pack 100b and a second higher-level controller 200b.

The battery life information providing apparatus 20 may be connected to the plurality of vehicles through the network. For convenience of description, the description will be made assuming that the first vehicle 10a may be a vehicle that is subject to life information calculation and the second vehicle 10b is a vehicle that provides data for a reference electric expense. The first vehicle 10a and the second vehicle 10b may be of the same type.

The battery life information providing apparatus 20 may include an electric expense determining unit 320 that calculates a reference electric expense based on second data received from the second vehicle 10b, a determining unit 340 that determines whether the first battery pack 100a of the first vehicle 10a is replaced, based on the reference electric expense and data regarding the first vehicle 10a, a calculating unit 360 that calculates a first replacement driving distance of the first vehicle 10a after replacement of the first battery pack 100a, and a diagnosing unit 380 that calculates life information regarding the first battery pack 100a.

Generally, the electric expense may mean a driving distance (km) of a vehicle relative to a consumed power (kWh). However, in the present specification, for convenience of description, the driving distance (km) of the vehicle relative to an accumulative discharging current (Ah) may be the unit of an electric expense.

According to an embodiment, the battery life information providing apparatus 20 may be connected to a plurality of second vehicles 10b and receive a plurality of pieces of second data. The second data may include an accumulative driving time and an accumulative driving distance of the second vehicle 10b, and an accumulative discharging current and an accumulative discharging voltage of the second battery pack 100b included in the second vehicle 10b.

The electric expense determining unit 320 may calculate second electric expenses based on the plurality of pieces of second data and calculate the reference electric expense and an average electric expense based on the second electric expenses.

According to an embodiment, the reference electric expense may be an electric expense for determining whether the first battery pack 100a included in the first vehicle 10a is replaced, and the average electric expense may be an electric expense for calculating the first replacement driving distance that is a driving distance of the first vehicle 10a after replacement of the first battery pack 100a.

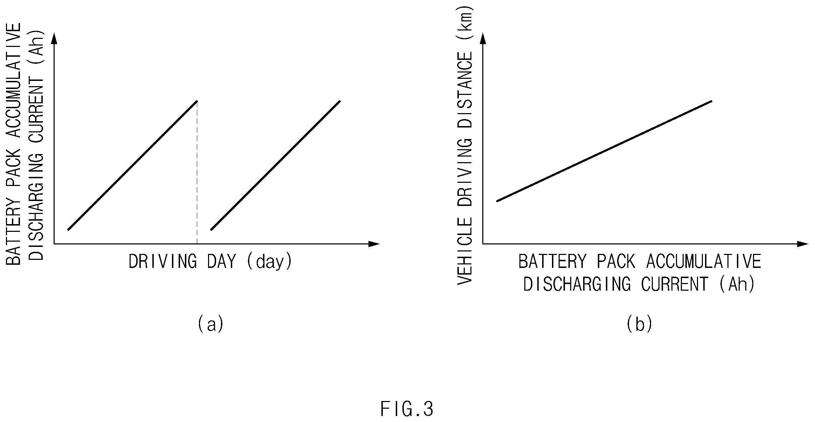

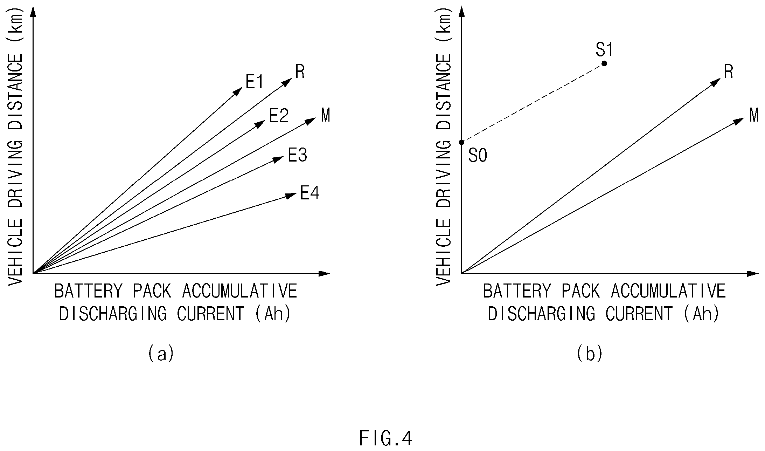

A method, performed by the electric expense determining unit 320, of determining the reference electric expense or the average electric expense will be described in detail with reference to FIGS. 3 and 4.

The electric expense determining unit 320 may select second data regarding a second vehicle having a battery pack not replaced among the second vehicles, and calculate a plurality of second electric expenses based on the selected second data.

The determining unit 340 may determine whether the first battery pack 100a of the first vehicle 10a is replaced, based on the reference electric expense and the first data. The first data may include an accumulative driving time and an accumulative driving distance of the first vehicle 10a, and an accumulative discharging current and an accumulative discharging voltage of the first battery pack 100a included in the first vehicle 10a.

According to an embodiment, the first accumulative driving distance may be a total distance the first vehicle 10a is driven until a life information calculation time since release of the first vehicle 10a. The first accumulative discharging current may be an accumulative discharging current after the first battery pack 100a is mounted on the first vehicle 10a.

Thus, when the first battery pack 100a is a replaced battery pack, the first accumulative driving distance may be greater than the first accumulative discharging current.

According to an embodiment, the first data may include the first accumulative driving distance and the first accumulative discharging current at the life information calculation time. On the other hand, the second data may include total data regarding a second accumulative driving distance change and a second accumulative discharging current change of the second vehicle with respect to a preset time period.

Thus, the electric expense determining unit 320 may determine whether the second battery pack 200a is replaced, based on state changes of the second vehicle 10b and the second battery pack 200b over time.

On the other hand, the first data may merely include data at the life information calculation time regarding the first vehicle 10a and the first battery pack 100a, such that the determining unit 340 may determine whether the first battery pack 100a is replaced, by introducing an additional determination criterion (e.g., the reference electric expense).

According to an embodiment, the determining unit 340 may show the reference electric expense on a driving distance plane with respect to the discharging current, and compare the first accumulative driving distance with respect to the first accumulative discharging current with the reference electric expense.

When the first accumulative driving distance with respect to the first accumulative discharging current exceeds the reference electric expense, that is, when the first accumulative driving distance with respect to the first accumulative discharging current on the driving distance plane with respect to the discharging current is above a reference expense graph, the determining unit 340 may determine that the first battery pack 100a of the first vehicle 10a is replaced.

A method, performed by the determining unit 340, of determining whether the battery pack is replaced will be described in detail with reference to FIG. 3.

The calculating unit 360 may calculate the first replacement driving distance that is a driving distance of the first vehicle 10a after replacement of the first battery pack 100a. The calculating unit 360 may calculate the first replacement driving distance by subtracting the driving distance before replacement of the first battery pack 100a from the first accumulative driving distance of the first vehicle 10a.

The calculating unit 360 may calculate the driving distance before replacement of the first battery pack 100a, based on the average electric expense, the first accumulative discharging current, and the first accumulative driving distance. A detailed calculation operation of the calculating unit 360 will be described with reference to FIG. 4.

The diagnosing unit 380 may calculate the life information regarding the first battery pack 100a based on the first replacement driving distance and the first data. The life information may include SOH information regarding the first battery pack 100a.

When the first battery pack 100a of the first vehicle 10a is replaced, the first accumulative driving distance may not correspond to the first accumulative discharging current of the first battery pack 100a. Thus, when the life information (e.g., an SOH) of the replaced first battery pack 100a is calculated by reflecting the first accumulative driving distance of the first vehicle 10a, it may be difficult to calculate accurate life information of the diagnosing unit 380.

For example, the first replacement driving distance may be less than the first accumulative driving distance of the first vehicle 10a at the life information determination time. Thus, when the life information of the first battery pack 100a is calculated based on the first accumulative driving distance, the SOH of the first battery pack 100a may be calculated as being less than an actual SOH.

When the SOH of the first battery pack 100a is calculated as being less than the actual SOH, accurate information may not be provided to the user and the user may not predict the state of the first battery pack 100a.

The first data may include a first accumulative discharging voltage that is an accumulative discharging voltage for the first battery pack 100a.

The diagnosing unit 380 may calculate the SOH of the first battery pack 100a for the first replacement driving distance. The diagnosing unit 380 may calculate the accumulative charging/discharging power of the replaced first battery pack 100a based on the first accumulative discharging voltage and the first accumulative discharging current, and calculate the SOH based on the accumulative charging/discharging power and the first replacement driving distance.

FIG. 3 is a view for describing an operating method of an electric expense determining unit, according to an embodiment disclosed herein.

More specifically, FIG. 3 is a view for describing a method of selecting the second data for the second vehicles having the second battery packs not replaced, from among the plurality of pieces of second data.

The electric expense determining unit 320 may collect the plurality of pieces of second data from the second vehicles of the same type as the first vehicle that is subject to life information calculation.

The electric expense determining unit 320 may select the second data regarding the second vehicles having the second battery packs not replaced from among the plurality of pieces of second data collected, and calculate the reference electric expense or the average electric expense based on the selected second data.

The electric expense determining unit 320 may calculate a second accumulative discharge current graph with respect to the number of driving days or a second accumulative driving distance graph with respect to a second accumulative discharging current, for a second vehicle, from a plurality of pieces of second data , and determine whether the second battery pack is replaced, based on the graph.

(a) of FIG. 3 shows a graph of a second accumulative discharging current changing with respect to the number of driving days. As shown in (a) of FIG. 3, when a period is included in which the second accumulative discharging current discontinuously decreases with respect to the number of driving days, the electric expense determining unit 320 may determine that the second battery pack corresponding to the second data is replaced, and exclude the second data from reference electric expense or average electric expense calculation.

(b) of FIG. 3 shows the second accumulative driving distance graph with respect to the second accumulative discharging current. As shown in (b) of FIG. 3, when the accumulative driving distance is not 0 km for the accumulative discharging current of 0 Ah, the electric expense determining unit 320 may determine that the second battery pack corresponding to the second data is replaced, and exclude the second data from reference electric expense or average electric expense calculation.

The electric expense determining unit 320 may select the second data corresponding to the second battery pack not replaced from among the plurality of pieces of second data and calculate the reference electric expense based on the selected second data, thereby more accurately identifying whether the first battery pack of the first vehicle that is subject to life information calculation is replaced.

The electric expense determining unit 320 may calculate the plurality of second electric expenses from the second data regarding the second vehicle including the second battery pack not replaced. The electric expense determining unit 320 may calculate the reference electric expense or the average electric expense based on the plurality of second electric expenses.

FIG. 4 is a view for describing a method for determining whether a battery pack is replaced, and a method for calculating a replacement driving distance.

(a) of FIG. 4 shows a plurality of second electric expenses E1, E2, E3, and E4, a reference electric expense R, and an average electric expense M.

The second electric expenses E1, E2, E3, and E4 shown in (a) of FIG. 4 are merely examples, and the electric expense determining unit 320 may calculate the reference electric expense R and the average electric expense M based on more second electric expenses than the second electric expenses shown in FIG. 4.

The electric expense determining unit 320 may calculate the second electric expenses E1, E2, E3, and E4 for the plurality of second vehicles by calculating the second accumulative driving distance with respect to the second accumulative discharging current. The second electric expenses E1, E2, E3, and E4 may respectively correspond to random second vehicles.

As described with reference to FIG. 3, the electric expense determining unit 320 may calculate the second electric expenses from the second data regarding the second vehicles including the second battery packs not replaced. Thus, the second electric expenses E1, E2, E3, and E4 used in reference electric expense calculation may pass through an original point of the driving distance (km) plane with respect to the accumulative discharging current (Ah).

According to an embodiment, the electric expense determining unit 320 may determine a third quartile electric expense of the plurality of second electric expenses as the reference electric expense.

The third quartile value may be a value between a median value and a maximum value. More specifically, the third quartile value may be a value in which materials having values of the third quartile or less are 75 % of all materials.

When the third quartile electric expense of the second electric expenses is a reference electric expense, the reference electric expense may be an electric expense corresponding to 75 % of all the second electric expenses for the second vehicles including the second battery packs not replaced.

According to an embodiment, the third quartile value may be a value that bisects the median value and the maximum value. Thus, the reference electric expense R may have a bisection value between a central electric expense (not shown) that is an electric expense corresponding to 50 % among all the second electric expenses E1, E2, E3, and E4 and a maximum electric expense (e.g., E1) that is a maximum value among all the second electric expenses.

The electric expense determining unit 320 may calculate the average electric expense from the second data regarding the second vehicles including the second battery packs not replaced.

According to an embodiment, the average electric expense M may be an average change rate of all the second electric expenses E1, E2, E3, and E4.

The reference electric expense R and the average electric expense M shown in (a) of FIG. 4 are shown as an example for convenience of description.

(b) of FIG. 4 is a view for describing a method, performed by the determining unit 340, of determining whether a battery pack is replaced.

FIG. 4 shows the reference electric expense R, the average electric expense M, and first data S1 of a first vehicle.

According to an embodiment, the first data S1 for the first vehicle that is subject to life information determination may include the first accumulative discharging current and the first accumulative driving distance.

The determining unit 340 may determine that the first battery pack of the first vehicle is replaced, when the first accumulative driving distance with respect to the first accumulative discharging current included in the first data S1 exceeds the reference electric expense R.

Referring to (b) of FIG. 4, the first data S1 may be above the reference electric expense R. That is, the first accumulative driving distance for the first accumulative discharging current included in the first data S1 may be in a region exceeding the reference electric expense R. Thus, the determining unit 340 may determine that the first battery pack of the first vehicle is replaced.

The calculating unit 360 may calculate the first replacement driving distance, based on the first accumulative discharging current, included in the first data S1, and the first accumulative driving distance.

When it is determined that the first battery pack is not replaced, the calculating unit 360 may not separately calculate the first replacement driving distance.

When the first battery pack is not replaced, the diagnosing unit 380 may calculate the life information regarding the first battery pack based on the first accumulative driving distance.

When it is determined that the first battery pack is replaced, the calculating unit 360 may calculate the first replacement driving distance, based on the average electric expense, the first accumulative discharging current, and the first accumulative driving distance.

For example, in (b) of FIG. 4, the determining unit 340 may determine that the first battery pack corresponding to the first data S1 is replaced, and the calculating unit 360 may calculate the replacement driving distance of the first vehicle.

According to an embodiment, the calculating unit 360 may calculate the first replacement driving distance by subtracting, from the first accumulative driving distance, a driving distance (a driving distance before replacement) for the accumulative discharging current of 0 Ah.

The calculating unit 360 may calculate the driving distance before replacement, based on the average electric expense, the first accumulative discharging current, and the first accumulative driving distance.

Initial data S0 shown in (b) of FIG. 4 is calculated by the calculating unit 360 based on the first data S1 and the average electric expense M, and may indicate a state of the first vehicle before replacement of the first battery pack.

When the first battery pack is replaced, the accumulative discharging current of the first battery pack may be 0 Ah. That is, the driving distance included in the initial data S0 may be a driving distance before replacement of the first battery pack.

Referring to (b) of FIG. 4, a gradient between the first data S1 and the initial data S0 may be identical to the average electric expense M.

The calculating unit 360 may calculate, as the first replacement driving distance by subtracting the driving distance before replacement, included in the initial data S0, from a first subject driving distance included in the first data S1.

When the first replacement driving distance is calculated, the diagnosing unit 380 may calculate the life information regarding the first battery pack based on the first replacement driving distance. According to an embodiment, the life information regarding the first battery pack may include, for example, the SOH of the first battery pack.

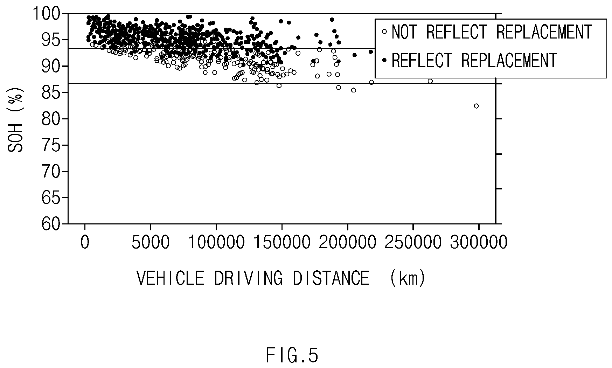

FIG. 5 is a view for describing life information calculated by a diagnosing unit according to an embodiment disclosed herein.

FIG. 5 shows a result of determining whether the first battery pack is replaced and calculating an SOH value based on the first replacement driving distance and the first data when the first battery pack is replaced and a result of calculating an SOH value based on the first accumulative driving distance and the first data without determining whether the first battery pack is replaced.

The SOH value calculated by reflecting replacement of the first battery pack may be greater than the SOH value calculated without reflecting replacement.

When the first battery pack is replaced, the SOH value indicating the remaining life or current performance of the first battery pack may be greater than that in a case without replacement of the first battery pack. That is, when replacement of the first battery pack is determined and the SOH is calculated based on the first replacement driving distance that is a driving distance after replacement of the first battery pack, a result close to the actual SOH value may be obtained.

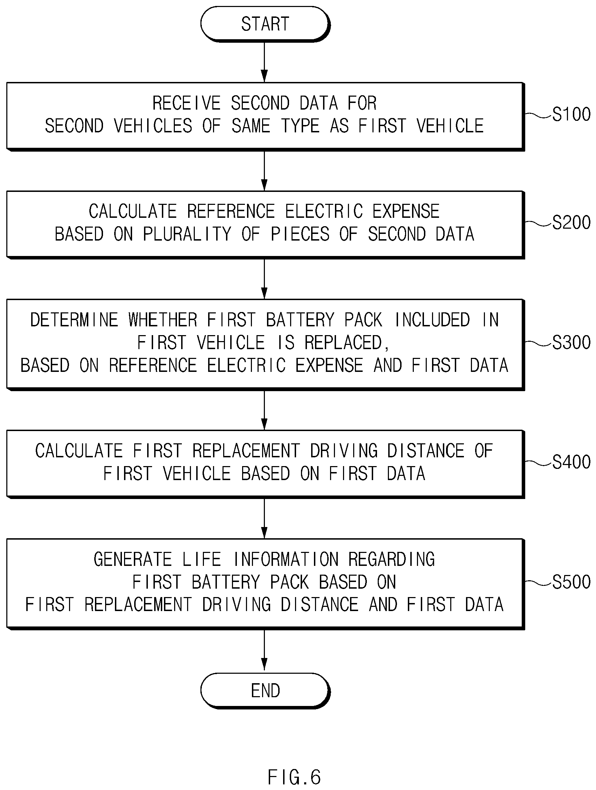

FIG. 6 is a view for describing an operating method of a battery life information providing apparatus, according to an embodiment disclosed herein.

The battery life information providing apparatus may receive a plurality of pieces of second data for second vehicles of the same type as a first vehicle, in operation S100.

The first vehicle may be a vehicle subject to life information calculation.

The battery life information providing apparatus may calculate a reference electric expense based on the plurality of pieces of second data, in operation S200.

The plurality of pieces of second data may include a plurality of second accumulative discharging currents for second battery packs respectively included in the second vehicles and a plurality of second accumulative driving distances for the second vehicles.

The battery life information providing apparatus may determine whether a second battery pack is replaced, and calculate the reference electric expense based on a plurality of pieces of second data for second vehicles including second battery packs not replaced.

More specifically, the battery life information providing apparatus may determine whether a second battery pack is replaced, based on a second accumulative discharging current graph with respect to an elapse of driving days or an accumulative driving distance graph with respect to an accumulative discharging current, and may not use the second data for reference electric expense calculation when the second battery pack is replaced.

The battery life information providing apparatus may determine whether a first battery pack included in a first vehicle is replaced, based on the reference electric expense and first data regarding the first vehicle, in operation S300.

The first data may include the first accumulative discharging current that is an accumulative discharging current of a first battery included in the first vehicle that is subject to life information calculation, or the first accumulative driving distance that is an accumulative driving distance of the first vehicle.

The battery life information providing apparatus may determine that the first battery pack is replaced, when the first accumulative driving distance for the first accumulative discharging current exceeds the reference electric expense.

More specifically, the battery life information providing apparatus may determine that the first battery pack is replaced, when the first accumulative driving distance for the first accumulative discharging current exceeds the reference electric expense in the driving distance plane for the discharging current.

The battery life information providing apparatus may calculate a first replacement driving distance of the first vehicle, based on the first data, in operation S400.

The first replacement driving distance may be a driving distance after replacement of the first battery pack in the first vehicle.

The battery life information providing apparatus may generate life information regarding the first battery pack based on the first replacement driving distance and the first data, in operation S500.

According to an embodiment, the first data may include an accumulative discharging voltage for the first battery pack that is subject to life information calculation.

The life information providing apparatus may calculate life information regarding the first battery pack based on the first accumulative discharging current and the first accumulative discharging voltage with respect to the first replacement driving distance.

When the life information providing apparatus calculates life information including an SOH by reflecting the first replacement driving distance, the accuracy of SOH calculation may be improved.

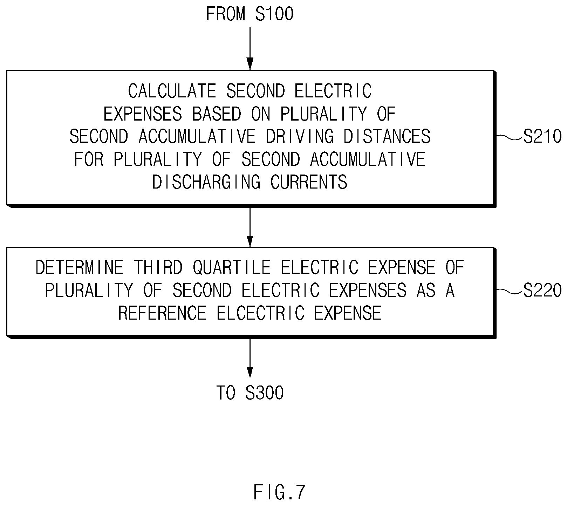

FIG. 7 is a view for describing an operating method of a battery life information providing apparatus, according to another embodiment disclosed herein.

Operation S200 of calculating a reference electric expense will be described in more detail with reference to FIG. 7.

The battery life information providing apparatus may calculate second electric expenses based on the plurality of second accumulative driving distances with respect to the plurality of second accumulative discharging currents, in operation S210,

The battery life information providing apparatus may calculate the second accumulative driving distance with respect to the second accumulative discharging current, as a second electric expense. The battery life information providing apparatus may calculate the plurality of second electric expenses respectively corresponding to second vehicles including second battery packs not replaced.

The battery life information providing apparatus may determine a third quartile electric expense of the plurality of second electric expenses as a reference electric expense, in operation S220. The third quartile electric expense may be an electric expense corresponding to 75 % of all the second electric expenses for the second vehicles including the second battery packs not replaced.

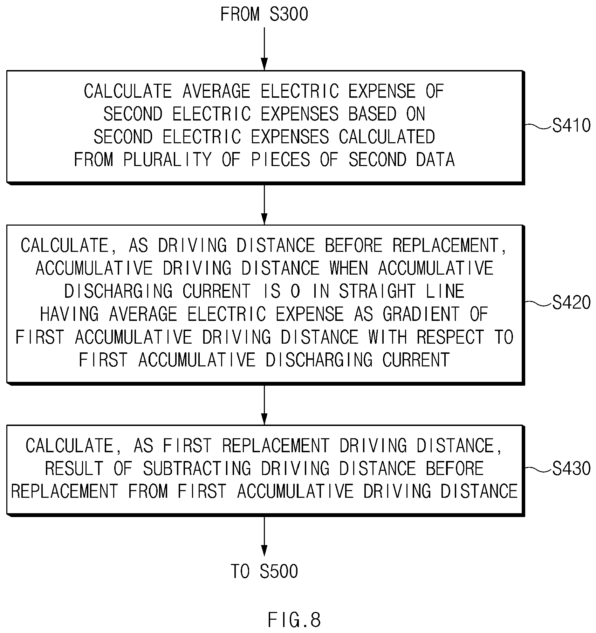

FIG. 8 is a view for describing an operating method of a battery life information providing apparatus, according to another embodiment disclosed herein.

Operation S400 of calculating a first replacement driving distance will be described in more detail with reference to FIG. 8.

The first data may include the first accumulative discharging current for the first battery pack and the first accumulative driving distance of the first vehicle including the first battery pack.

The battery life information providing apparatus may calculate an average electric expense of the second electric expenses based on the second electric expenses calculated from the plurality of pieces of second data, in operation S410.

The battery life information providing apparatus may calculate, as a driving distance before replacement, an accumulative driving distance when an accumulative discharging current is 0 in a straight line having an average electric expense as a gradient of the first accumulative driving distance with respect to the first accumulative discharging current, in operation S420.

More specifically, the battery life information providing apparatus may show a straight line having a gradient that is the same as an average electric expense in a driving distance plane with respect to a discharging current.

The straight line may pass the first accumulative driving distance with respect to the first accumulative discharging current. For the straight line, when the accumulative discharging current is 0, the accumulative driving distance may be the driving distance before replacement of the first battery pack.

The battery life information providing apparatus may calculate, as the first replacement driving distance, a result of subtracting the driving distance before replacement from the first accumulative driving distance, in operation S430.

By subtracting the driving distance before replacement from the first accumulative driving distance, the battery life information providing apparatus may calculate an actual distance the first vehicle is driven, since replacement of the first battery pack.

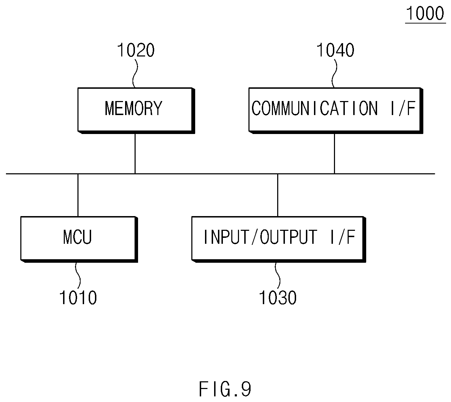

FIG. 9 is a block diagram showing a hardware configuration of a computing system for performing an operating method of a battery life information providing apparatus, according to an embodiment disclosed herein.

Referring to FIG. 9, a computing system 1000 according to an embodiment disclosed herein may include a microcontroller unit (MCU) 1010, a memory 1020, an input/output interface (I/F) 1030, and a communication I/F 1040.

The MCU 1010 may execute various programs stored in the memory 1020 (e.g., a relay control program included in a battery pack, a program for collecting voltage, current, temperature, internal resistance, impedance, the number of times of charge and discharge, charging/discharging current, charging/discharging voltage, etc.), or process data collected through such programs. According to an embodiment, the MCU 1010 may be a processor for performing a function of the battery life information providing apparatus 10 shown in FIG. 1 described above or a processor for performing a function of the higher-level controller, and a processor for performing functions of the data processing apparatus 20 shown in FIG. 2 described above.

The memory 1020 may store driving data and/or state data and store various programs regarding collection of battery data and data processing. The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data, may be various devices capable of supporting wired or wireless communication. For example, the battery life information providing apparatus may transmit and receive the driving data and/or the state data directly to or from the vehicle through the communication I/F 1040. The battery life information providing apparatus may also transmit and receive the driving data and/or the state data to or from a separately provided external server through the communication I/F 1040.

As such, a computer program according to an embodiment disclosed herein may be recorded in the memory 1020 and processed by the MCU 1010, thus being implemented as a module that performs functions shown in FIGS. 1 and 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery life information providing apparatus comprising:
a determining unit configured to determine whether a first battery pack included in a first vehicle is replaced, based on a reference electric expense and first data regarding the first vehicle;
a calculating unit configured to calculate a first replacement driving distance of the first vehicle, based on the first data; and
a diagnosing unit configured to calculate life information regarding the first battery pack based on the first replacement driving distance and the first data.

2. The battery life information providing apparatus of claim 1, further comprising an electric expense determining unit configured to receive a plurality of pieces of second data for second vehicles of the same type as a first vehicle and calculate the reference electric expense based on the plurality of pieces of second data.

3. The battery life information providing apparatus of claim 2, wherein the plurality of pieces of second data comprise a plurality of second accumulative discharging currents for second battery packs respectively included in the second vehicles and a plurality of second accumulative driving distances for the second vehicles.

4. The battery life information providing apparatus of claim 3, wherein the electric expense determining unit is further configured to determine whether a second battery pack is replaced, and calculate the reference electric expense based on the plurality of pieces of second data for the second vehicles comprising second battery packs not replaced.

5. The battery life information providing apparatus of claim 3, wherein the electric expense determining unit is further configured to calculate second electric expenses based on the plurality of second accumulative driving distances with respect to the plurality of second accumulative discharging currents and determine a third quartile electric expense of the second electric expenses as the reference electric expense.

6. The battery life information providing apparatus of claim 5, wherein the electric expense determining unit is further configured to calculate an average electric expense of the second electric expenses,
the first data comprises a first accumulative discharging current for the first battery pack and a first accumulative driving distance for the first vehicle, and
the calculating unit is further configured to calculate, as a driving distance before replacement, an accumulative driving distance when an accumulative discharging current is 0 in a straight line having an average electric expense as a gradient of the first accumulative driving distance with respect to the first accumulative discharging current, and calculate, as the first replacement driving distance, a result of subtracting the driving distance before replacement from the first accumulative driving distance.

7. The battery life information providing apparatus of claim 6, wherein the first data further comprises a first accumulative discharging voltage for the first battery pack, and
the diagnosing unit is further configured to calculate the life information based on the first accumulative discharging current and the first accumulative discharging voltage with respect to the first replacement driving distance.

8. The battery life information providing apparatus of claim 1, wherein the first data comprises a first accumulative discharging current for the first battery pack and a first accumulative driving distance for the first vehicle, and
the determining unit is further configured to determine that the first battery pack is replaced, when the first accumulative driving distance with respect to the first accumulative discharging current exceeds the reference electric expense.

9. An operating method of a battery life information providing apparatus, the operating method comprising:
determining whether a first battery pack included in a first vehicle is replaced, based on a reference electric expense and first data regarding the first vehicle;
calculating a first replacement driving distance of the first vehicle, based on the first data; and
calculating life information regarding the first battery pack based on the first replacement driving distance and the first data.

10. The operating method of claim 9, further comprising:
receiving a plurality of pieces of second data for second vehicles of the same type as a first vehicle; and
calculating the reference electric expense based on the plurality of pieces of second data.

11. The operating method of claim 10, wherein the plurality of pieces of second data comprise a plurality of second accumulative discharging currents for second battery packs respectively included in the second vehicles and a plurality of second accumulative driving distances for the second vehicles.

12. The operating method of claim 11, wherein the calculating of the reference electric expense included in the battery life information providing apparatus comprises:
determining whether a second battery pack is replaced; and
calculating the reference electric expense based on the plurality of pieces of second data for the second vehicles comprising second battery packs not replaced.

13. The operating method of claim 11, wherein the calculating of the reference electric expense comprises:
calculating second electric expenses based on the plurality of second accumulative driving distances with respect to the plurality of second accumulative discharging currents; and
determining a third quartile electric expense of the second electric expenses as the reference electric expense.

14. The operating method of claim 13, wherein the first data comprises a first accumulative discharging current for the first battery pack and a first accumulative driving distance for the first vehicle, and
the calculating of the first replacement driving distance comprises:
calculating an average electric expense of the second electric expenses;
calculating, as a driving distance before replacement, an accumulative driving distance when an accumulative discharging current is 0 in a straight line having an average electric expense as a gradient of the first accumulative driving distance with respect to the first accumulative discharging current; and
calculating, as the first replacement driving distance, a result of subtracting the driving distance before replacement from the first accumulative driving distance.

15. The operating method of claim 14, wherein the first data further comprises a first accumulative discharging voltage for the first battery pack, and
the calculating of the life information regarding the first battery pack comprises calculating the life information based on the first accumulative discharging current and the first accumulative discharging voltage with respect to the first replacement driving distance.

16. The operating method of claim 9, wherein the first data comprises a first accumulative discharging current for the first battery pack and a first accumulative driving distance for the first vehicle, and
the determining of whether the first battery pack is replaced comprises determining that the first battery pack is replaced, when the first accumulative driving distance with respect to the first accumulative discharging current exceeds the reference electric expense.
